# EUROPEAN PATENT APPLICATION

(11) **EP 1 477 852 A1**
(43) Date of publication of application: **17.11.2004**
(21) Application number: 03253057.8
(22) Date of filing: 16.05.2003
(51) Int. Cl.: G03F 7/20

(54) **Lithographic apparatus, device manufacturing method, and device manufactured thereby**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

A lithographic projection apparatus comprising a collision protection apparatus for protecting internal parts against damage from a collision. The collision protection apparatus can comprise at least one damper for applying a braking force and/or for absorbing a collision force, reducing or eliminating any damage to delicate and costly parts. The collision protection apparatus can also monitor the position and velocity of a moving part to determine when a collision is likely.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reject incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

During the manufacturing process the movement of the tables, and the mask or substrate mounted on it, may be controlled with as many as six degrees of freedom (translation along three mutually orthogonal axes and rotation about those axes). Movements can occur at high velocity. At high velocity the kinetic energy of the table is high and a collision is likely to cause damage to delicate and expensive parts of the apparatus. Collisions may occur in several circumstances, for example:
- horizontally with the walls of the apparatus defining the area the table can move in;
- horizontally with other tables in a multiple stage device (these have two or more tables operating in the same area);
- vertically with the parts of the imaging system, for example the lens.

It is an object of the present invention to reduce the damage caused by such a collision.

This and other objects are achieved according to the invention in a lithographic apparatus as specified in the opening paragraph, characterized by a collision protection apparatus for protecting the substrate table, or other internal parts, against damage from a collision.

The provision of a collision protection apparatus allows any damage to parts involved in a collision within the lithographic apparatus to be minimized or reduced to zero. In the event of a collision no expensive repair costs are incurred and the lithographic apparatus can return to production with very little lost production time.

In one advantageous embodiment of the present invention, the apparatus further comprises :
- at least one sensor for measuring the position and velocity of said table; and
- a controller for controlling the velocity of the table on the basis of the measured position and velocity from the at least one sensor, knowledge of the positions of potential obstacles to the table and knowledge of the stopping distance of the table.

The collision protection apparatus then takes an active role to ensure that collisions cannot occur. The position of the table relative to the known positions of obstacles determines the maximum allowed velocity of the table. If an obstacle is close, velocity towards the obstacle is restricted to small magnitudes. The actual velocity allowed is calculated from the stopping distance. Limiting the velocity in this way ensures that there is always sufficient stopping distance to avoid a collision. Furthermore, in the worst case when a collision does occur the velocity will be small, limiting the damage.

In a further advantageous embodiment of the present invention, the apparatus further comprises:
- at least one sensor for measuring the distance between the table and an obstacle and/or for measuring the velocity of the table towards an obstacle; and
- a controller for ensuring that the measured distance remains greater than a predetermined minimum distance and/or for ensuring that the measured velocity does not exceed a predetermined maximum speed.

The measured value of distance and/or speed allows the table to be controlled within predetermined limits. A minimum distance provides a safety margin to avoid collisions. Limiting the maximum velocity limits the maximum kinetic energy and reduces the damage arising from a collision. In the case when both velocity and distance are measured, the limit of velocity may be set to a value that can safely be decelerated before a collision, should the distance become smaller than the minimum distance.

The controller may be a switch that simply powers down the apparatus when the predetermined limits are exceeded. Optionally, should the distance become smaller than the allowed minimum distance, an emergency braking or reverse movement can be initiated using a damper or actuator.

According to a further advantageous embodiment of the invention the apparatus may further comprise:
- a rim which projects beyond at least one edge of the table, the rim being connected to the table by at least one damper for relative movement thereto.

In the event of a collision occurring on the edge with the protruding rim, the rim moves relative to the table while the damper limits the force transmitted to the table. The table is therefore protected from damage when a collision occurs. The at least one damper may be passive or active and may operate by, for example, viscous forces in an oil damper, eddy currents due to electromagnetic effects or friction. Alternatively, the at least one damper may deform by elastic or plastic deformation. If the damper is of a resilient type, for example a shape-memory metal exhibiting super-elastic properties, the rim will return to its previous position after impact. The lithographic apparatus can then return to production with minimal delay.

According to another advantageous embodiment of the invention, the collision protection apparatus may further comprise
- a rim which projects beyond the edges of the table in a plane parallel to a direction of movement of the table;
- two dampers connecting a first side of the rim to a first side of the table;
- two connecting rods connecting a second side of the rim, adjacent to the first side, to the table, the connecting rods forming two opposite sides of a parallelogram in the plane parallel to the direction of movement.

In this case, if an off-center collision force is applied to the first side of the table (or the side opposite), the parallelogram configuration of the connecting rods constrains the rim to move in a single direction. In the event of an import on that side there is no tendency for the rim to rotate and the force is spread evenly between the two dampers.

According to another advantageous embodiment of the present invention, the collision protection apparatus may further comprise:
- a rim which projects beyond the edges of the table in a plane parallel to a direction of movement of the table; and
- a respective first and a second damper connecting each side of the rim to the table.

This configuration allows the respective first and second damper to be active when an impact occurs on the crash protection rim. The dampers on adjacent sides of the rim act to ensure that the force of an off-center crash is evenly distributed between the dampers which are active.
Preferably the respective first and second damper connects each corner of the rim to the table, and the respective first damper is connected between a first point on the rim and a second point on the table, and the respective second damper is connected between the first point on the rim and a third point on the table, wherein the first, second and third points form a triangle in the plane horizontal to the direction of movement.

This configuration also allows a compact construction.

Preferably, the support structure comprises a mask table for holding a mask and the collision protection apparatus is for protecting the mask table against damage from a collision. This allows the mask table to benefit from collision protection.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
characterized by
- measuring the position and/or velocity of said moving part; and
- determining when a collision between a moving part of an apparatus and an obstacle is likely to occur.

The damage caused to parts of the apparatus involved in a collision can then be reduced. A damping force absorbs the force of an impact to dissipate the kinetic energy and ensure that the parts involved in the collision are not damaged.

Using the measured position and/or velocity it is possible to predict when a collision is likely. For example, a moving part may have moved into the safety distance around another part. Alternatively a moving part may be moving too fast to stop before hitting an obstacle.

A braking force may be applied to reduce the velocity of a moving part when it is determined a collision is likely. Ideally, the braking force will stop the movement before any collision occurs. However, it will also reduce the kinetic energy of the moving part with a subsequent reduction in damage if the movement is not stopped.

According to an advantageous embodiment of the present invention, the step of measuring may measure the position and velocity of said moving part and the method may further comprise:
- comparing the measured position and velocity with known positions of obstacles and a known stopping distance of the moving part; and
- controlling the velocity of said moving part dependent upon the result of said comparison.

Thus the velocity can be controlled to always allow sufficient stopping distance to avoid a collision.

According to a further advantageous embodiment of the present invention, the step of measuring may measure the distance between said moving part and said obstacle and/or measure the velocity of said moving part towards said obstacle, the method further comprising:
- controlling the velocity of the moving part to ensure that the measured distance is greater than a predetermined minimum distance and/or to ensure that the measured velocity does not exceed a predetermined maximum velocity.

The controller may be a simple switch that powers down the apparatus when a limit is exceeded. It is therefore possible to maintain a safety distance around an obstacle. If a moving part gets closer to an obstacle than the safety distance a braking force can be applied to stop it before a collision. When the system is applied in a vertical direction gravity will apply a braking force to the moving part. Placing a limit on the velocity ensures the kinetic energy of a moving part is low enough for any collision that may occur not to cause damage.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e*.*g*. with a wavelength of 365, 248, 193, 157 or 126 nm) and EUV (extreme ultra-violet radiation, *e*.*g*. having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 is a plan view of a crash rim according to a first embodiment of the present invention;
Figure 3 is a side view of a crash rim according to a first embodiment of the present invention;
Figure 4 is a plan view of an off-center impact on a crash rim according to the first embodiment of the present invention;
Figure 5 is a plan view of the arrangement of dampers according to a second embodiment of the present invention;
Figure 6 is a plan view of the relative positions of two wafer tables in a multi-stage apparatus, according to a second embodiment of the present invention;
Figure 7 is a plan view of the arrangement of dampers according to a third embodiment of the present invention;
Figure 8 depicts a field of maximum velocities of a pair of substrate tables in a fourth embodiment of the invention;
Figure 9 is a graph showing the variation of maximum velocity with distance from an obstacle in a fourth embodiment of an invention;
Figure 10 depicts a lithographic apparatus according to a fifth embodiment of the present invention;
Figure 11 is a plan view of a sensor array according to a fifth embodiment of the present invention;
Figure 12 depicts a lithographic apparatus according to a sixth embodiment of the present invention; and
Figure 13 depicts a lithographic apparatus according to a seventh embodiment of the present invention.

In the Figures, corresponding reference symbols indicate corresponding parts.

### Embodiment 1

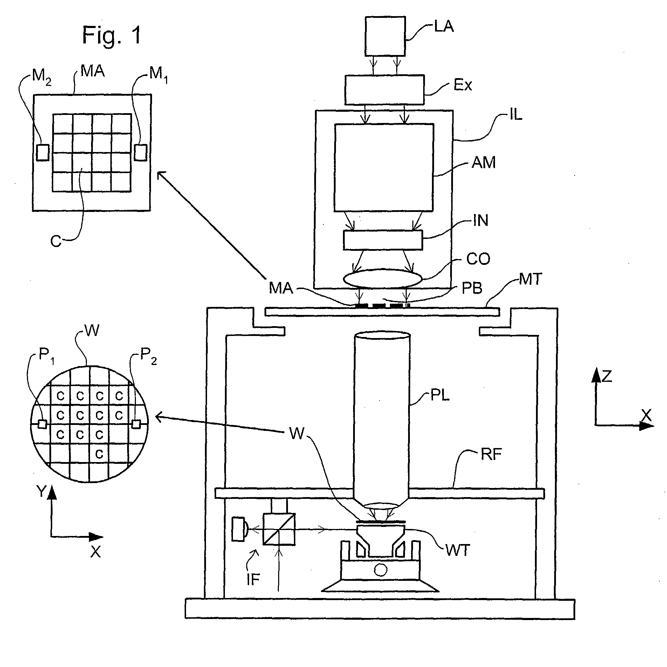

Figure 1 schematically depicts a lithographic projection apparatus according to a particular embodiment of the invention. The apparatus comprises:
· a radiation system Ex, IL, for supplying a projection beam PB of radiation (UV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g*. a resist-coated silicon wafer), and connected to second positioning means for accurately positioning the substrate with respect to item PL;
· a projection system ("lens") PL (*e.g.* a refractive lens) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example *(e.g.* with a reflective mask). Alternatively, the apparatus may employ another kind of patterning means, such as a programmable mirror array of a type as referred to above.

The source LA (*e.g.* an Hg lamp) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF); the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e*.*g*. the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

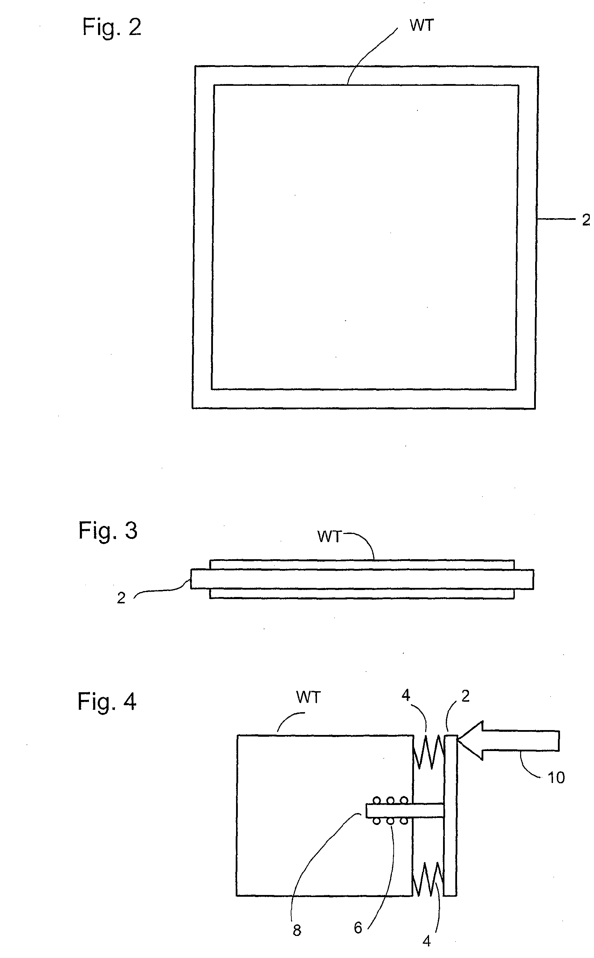

Figure 2 is a plan view of the wafer table WT equipped with a crash protection rim 2. A side view of the crash protection rim 2 and wafer table WT is shown in figure 3. The rim 2 projects out from the edges of the water table WT and is mounted so that it can move relative to the wafer table WT when an impact occurs.

At least one damper connects the rim 2 to the wafer table WT. In this embodiment the damper is constructed from a super-elastic memory metal. For example a metal from the family of alloys known as "nitinol" comprising a nearly equal mixture of nickel (55% by weight) and titanium. Other constructions of damper are possible, for example an oil or elastic spring based damper or a damper designed to deform plastically when an impact occurs. When the rim hits an obstacle it moves relative to the wafer table WT. The damper is compressed and the force of the impact reaching the water table WT is reduced. In this embodiment the use of a super elastic memory metal enables the damper to be reduced in size and weight over the alternatives.

Figure 4 illustrates the arrangements of dampers 4 on one side of the crash protection rim 2. Two dampers 4 are mounted at two corners of the wafer table WT, connecting the wafer table WT and the rim 2. A rod 8 is attached to the crash protection rim 2 and is constrained to move in a single direction by a linear bearing 6. In this way an off-center impact, such as that illustrated by the arrow 10, is spread evenly between the two dampers 4. If the rod 8 and bearing 6 were not present an off-center impact would be focused on one of the dampers 4 and not spread evenly. (The rim 2 would tend to rotate as well as moving in the direction of the force.) The crash stroke for an off-center impact would then be larger than a central impact, which presents problems with design.

The physical design of the dampers must consider the likely kinetic energy and forces involved in an impact, the maximum force which can be transferred to the wafer table WT without causing damage, and the maximum allowable crash stroke. It is desirable for the crash stroke to be as small as possible, reducing the distance that the rim 2 must project out of the wafer table WT and allowing a smaller, lighter construction.

The crash rim also incorporates a positioning mechanism to ensure that it remains in the correct position during normal operation and returns to the correct position after a collision. The position of the crash rim relative to the table is monitored by a crash detection sensor. Should a collision occur the crash detection sensor detects that the rim has moved and stops the manufacturing process.

Although figure 4 only illustrates a rim 2 provided on one side of the wafer table WT the construction can be applied to the other sides if required. Furthermore, although the construction of a crash rim for a water table WT has been described, it could equally be applied to a mask table MT.

### Embodiment 2

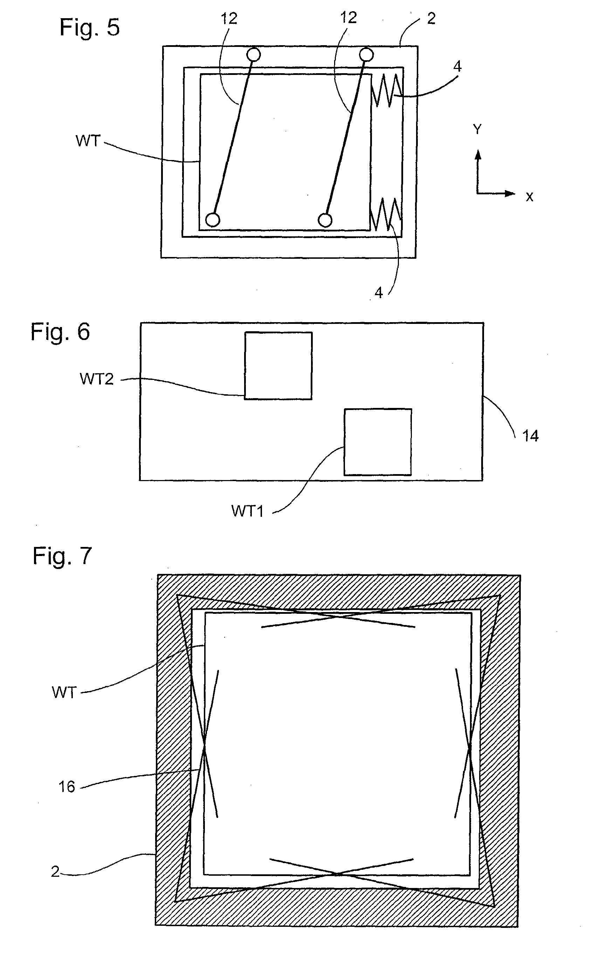

Figure 5 illustrates an alternative construction of the crash rim of the first embodiment. The construction is as described for the first embodiment save for the differences set out below.

In this embodiment the crash rim 2 extends around all sides of the wafer table WT as a single piece construction. Two dampers 4 are connected between the side of the rim 2 furthest from the wafer table WT in the X direction and the side of the wafer table WT directly opposite. A pair of connecting members 12, connect the side of the crash rim 2 furthest from the wafer table WT in the Y direction with the side of the wafer table furthest from that side of the crash rim 2 via pin joints. The connecting members 12 form a parallelogram configuration, being connected in a position further in the +X direction on the crash rim 2 than on the wafer table WT. The connecting members 12 are pre-tensioned springs and will therefore only deform in the Y direction when a force greater than the pretensioning force is applied.

This construction allows the mechanism to spread the force of off-center impacts in the X direction between the dampers 4. The force in the Y direction of an import predominantly in the X direction will be small, less than the pretensioning force. The connecting members 12 therefore do not deform and rotate in the parallelogram configuration. This prevents rotation of the crash rim 2 and spreads the force evenly between the dampers 2.

For impacts in the Y direction the connecting members 12 themselves function as the dampers because the force is greater than the pretensioning force. However, in the Y direction there is no mechanism to spread the force of an off-center impact between the two connecting members 12 because the crash rim 2 can rotate.

The construction of the crash rim is optimized based on the obstacles likely to be faced by a wafer table WT when moving in a multi stage device. Figure 6 illustrates two wafer tables WT1, WT2 moving in a multistage device. The area of movement is defined by a rectangular wall 14. The wafer table WT1 can collide with the wall 14 or the other wafer table WT2. In the +X and -X directions any off-center impact is spread evenly between the dampers 4 by the parallelogram assembly of the connecting members 12 as described above. In the -Y direction the wafer table WT1 can only hit the wall. Any impact in this direction will therefore be spread evenly across the crash protection rim on that side. In the +Y direction the wafer table WT1 can hit the other wafer table WT2. However, the small space between the two wafer tables in this situation leads to a low crash velocity and a lower crash force than in the X direction. It is therefore possible to absorb the force without providing a compensating mechanism to spread the force evenly between the connecting members 12. (A typical crash stoke in the +Y direction would be 3mm.)

In this embodiment only two dampers and two pre-tensioned springs are required. This allows the overall construction to be light and inexpensive. The construction is optimized so that the crash rim is only prevented from rotating in the direction where an off-centre collision is more likely. The construction of this embodiment can easily be adapted to provide crash protection for a mask table.

### Embodiment 3

Figure 7 is a plan view of the construction of a crash protection rim according to a third embodiment of the present invention. The construction is the same as for the first embodiment, save as described below.

A single piece crash protection rim 2 is connected to the wafer table WT by eight dampers 16. As with the first embodiment, the dampers 16 are constructed from a super-elastic memory metal, but alternatives such as oil or elastic spring dampers may also be used. Each comer of the crash protection rim has two dampers attached to a common point. The dampers from each corner of the rim are connected in a triangular layout to positions on the wafer table WT.

The dampers 16 will buckle under a compressive load, they are only active when subjected to a tensile load. Therefore, two dampers will be active when a collision with one side of the crash protection rim occurs. In operation, the dampers 16 operate in a similar manner to pretensioned springs and only deform when the crash force is higher then the pretensioned force. The wires perpendicular to the crash direction will not deform because the load is not higher than the pretensioned force.

The pretension force in the x and y directions does not have to be equal. Both the ratio of the likely collision force in the x direction to the likely collision force in the y direction and the x:y ratio of the rim dimension can be used to optimize the ratio of the x:y pretensioned force.

The construction of the embodiment can easily be adapted for a mask table. Although a triangular layout of dampers has been described a rectangular arrangement can also be used.

### Embodiment 4

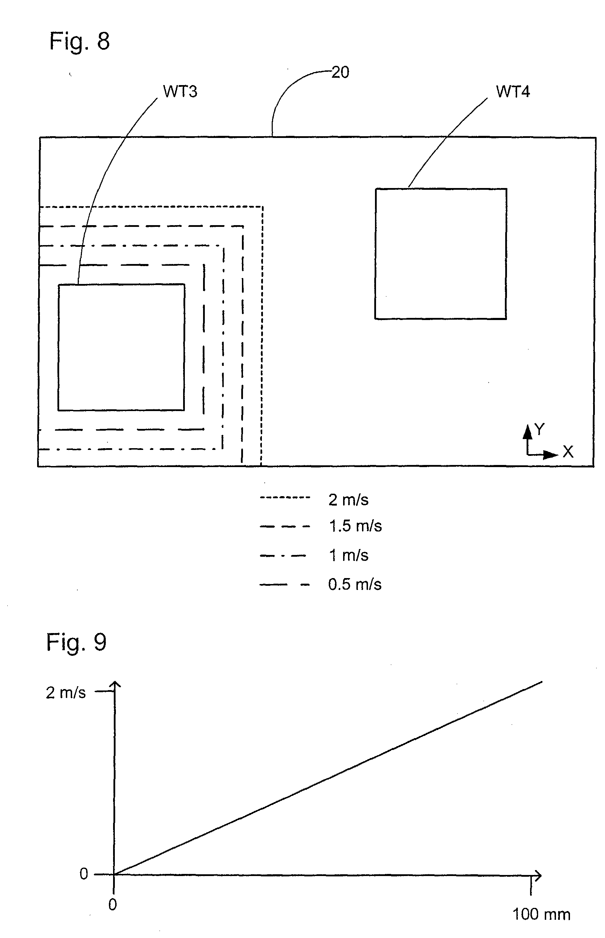

Figure 8 illustrates a fourth embodiment of the present invention. The construction of this embodiment is the same as the first save as described below.

Wafer tables WT3, WT4 form part of a multi-stage apparatus and move in a common area defined by the wall 20. In this embodiment a crash protection rim is not provided on the wafer tables WT3, WT4. Instead, at least one sensor (not illustrated) measures the position and velocity of the wafer tables WT3, WT4.

A controller calculates maximum allowed velocities of the wafer tables WT3, WT4 using the position of potential obstacles. For the wafer table WT3 in Figure 8, potential obstacles are formed by the other wafer table WT4 and the wall 20. The controller calculates the maximum allowed velocity using the distance from the wafer table WT to the obstacle. In this embodiment a linear relationship between distance to an obstacle and the maximum velocity in that direction, illustrated in Figure 9, is used. The contour lines in Figure 8 illustrate applying this relationship to the wafer table WT3. From figure 8 it can be seen that the wall 20 in the -X direction is close to the wafer table WT3. In this direction the maximum velocity is limited to only approximately 0.4 m/s. However, in the +X direction, the only obstacle is the other wafer table WT4, which is greater than 100mm away. In this direction the maximum permitted velocity is 2 m/s.

By controlling the velocity in this way the kinetic energy of the wafer table WT3 can be controlled to be small in situations where a collision is more likely to occur. Additionally the maximum velocity is set to be sufficient to allow the wafer table WT3 to stop before reaching the obstacle. In a situation when the controller determines that a collision is likely to occur, an emergency braking is initiated. This emergency braking can be initiated through electromagnetic eddy currents, friction, and other means. Alternatively, the velocity could be reversed when a collision is likely to occur.

Other maximum velocity profiles than the one in Figure 9 can be used. For example, the velocity profile may calculated with knowledge of the stopping distance at each velocity. This will give a non-linear variation to the velocity profile.

A crash protection rim of the above described first to third embodiments may also be provided in a lithographic apparatus fitted with the controlled maximum velocity system of this embodiment.

### Embodiment 5

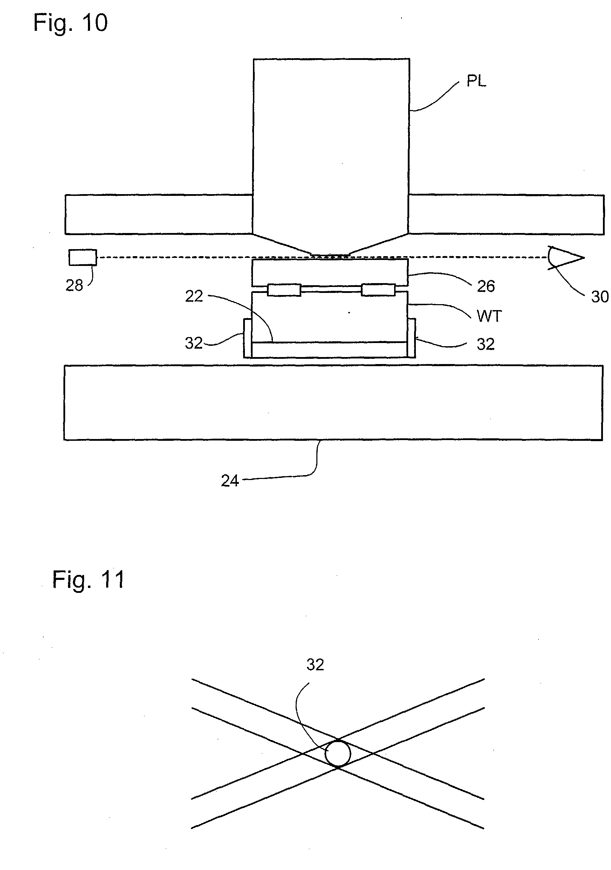

A fifth embodiment of the present invention is depicted in Figure 10. The construction of this embodiment is as for the first embodiment, save as described below. In this embodiment the wafer table WT is a driven by a planar motor 22 above a magnet plate 24. The planar motor is controlled with six degrees of freedom (translation and rotation about three mutually orthogonal axes). A mirror block 26 is mounted above the wafer table WT for use when aligning the wafer with the projection lens PL.

A light source 28 is attached to one side of the apparatus and a corresponding detector 30 is attached to the opposite side of the apparatus. The light source 28 and detector 30 are arranged just below the projection lens PL. Thus, when the mirror block 26 approaches the projection lens PL the light source is partially or fully obscured.

Gap sensors 32 are provided at the lower edge of the wafer table. They measure the distance from the bottom of the planar motor 22 to the magnet plate 24. This provides an indirect measure of the distance from the top of the mirror block 26 to the projection lens PL. (The combined height of the wafer table WT and mirror block 26 is known, as is the distance from the magnet plate to the projection lens PL.)

In operation a controller monitors the output from the light source detector 30 and the gap sensors 32 to determine the distance of the mirror block from the projection lens PL. In normal operation, the wafer table is controlled to keep the wafer table WT a minimum distance from the projection lens PL. If it is determined that the mirror block 26 is too close to the projection lens PL an emergency stop can be initiated. The emergency stop could be active, for example applying a braking force, or passive, for example turning off the power supply and allowing gravity to decelerate the table. Alternatively, the wafer table WT can be automatically moved down in an emergency to avoid the risk of a collision.

Vertical velocity is also measured by the gap sensors 32. The controller then limits the vertical velocity of the wafer table WT and hence reduces the damage caused in a collision should one occur. The maximum vertical velocity can be chosen such that when an emergency stop occurs because the wafer table WT is too close to the mirror block 26, the deceleration due to gravity will stop the wafer table WT before a collision occurs.

Figure 11 illustrates a plan view of the arrangement of lasers as the light source 28 in the present embodiment. It provides thorough coverage of the area below the projection lens PL but does not impinge on the exposure area 32.

Although this embodiment has been described using vertical distance and vertical velocity, it can also be applied to other directions.

### Embodiment 6

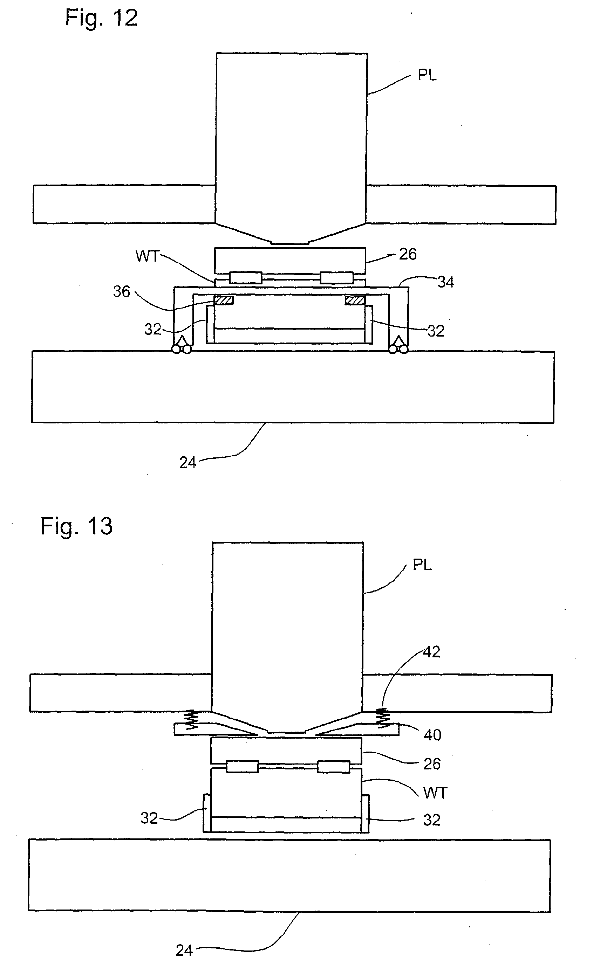

A sixth embodiment of the present invention is illustrated in Figure 12. The construction of the sixth embodiment is as for the fifth embodiment, save as described below.

In this embodiment a mechanical limiter 34 is mounted above the wafer table WT. The limiter 34 has legs mounted on bearings 38 which allow it to move freely over the magnet plate 24 in horizontal directions. However, the bearings 38 do not allow any vertical movement of the limiter 34. The mechanical limiter 34 follows the horizontal movements of the wafer table WT over the magnet plate 24.

In the event that the wafer table WT moves too high the protrusions 36 engage with the top bar of the limiter 34 and prevent any further vertical movement. A vertical collision with the projection lens PL cannot then occur.

Although the operation of the limiter protects the components of the projection lens PL from damage in a collision, there is a possibility that the wafer table WT could damaged if the engagement of the protrusions 36 with the limiter 34 is violent. For this reason the gap sensors monitor the gap between the planar motor 22 and the magnet plate 24 as an indirect measure of the gap between the protrusions 36 and the limiter 34. When the distance is such that the protrusions 36 are likely to engage with the limiter 34, the vertical speed can be limited to a value which minimizes the possibility of damage to the wafer table WT.

### Embodiment 7

A seventh embodiment of the present invention is illustrated in Figure 13. The construction of the seventh embodiment is as for the fifth embodiment, save as described below.

In this embodiment a crash protection rim 40 is provided on the reference frame. The crash rim 40 can move relative to the reference frame in a vertical direction and is mounted on the reference frame by dampers 42. The lower face of the crash rim 40 extends below the projection lens PL by a distance greater than the maximum crash stroke required by the dampers to absorb a collision.

In the event of a collision between the mirror block 26 and the projection lens PL the dampers 42 compress to absorb the force of the impact.

The design of crash rim aims to minimize the crash stroke required by the dampers, and hence the distance that the crash rim 40 must extend below the projection lens PL. An indirect measure of the distance of between the crash rim 40 and the mirror block 26 is provided by the gap sensors 32. With this information the vertical speed can be limited when the distance is small, reducing the kinetic energy of any collision and allowing a smaller crash stroke of the dampers 42.

The techniques in the above described first to third embodiments could be applied to the crash rim 40 to cope with off-center crashes.

Whilst specific embodiments of the invention have been described above, it will be appreciated that the invention may be practiced otherwise than as described. The description is not intended to limit the invention.

For example, the features of the various embodiments could be combined. In particular, a crash protection rim of the first to third embodiment could be provided in the systems of the fourth to seventh embodiments.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; **characterized by**
- a collision protection apparatus for protecting the substrate table, or other internal parts, against damage from a collision.

2. An apparatus according to Claim 1 wherein the collision protection apparatus further comprises:
- at least one sensor for measuring the position and velocity of said table; and
- a controller for controlling the velocity of the table on the basis of the measured position and velocity from the at least one sensor, knowledge of the positions of potential obstacles to the table and knowledge of the stopping distance of the table.

3. An apparatus according to Claim 1 wherein the collision protection apparatus further comprises:
- at least one sensor for measuring the distance between the table and an obstacle and/or for measuring the velocity of the table towards said obstacle; and
- a controller for ensuring that the measured distance remains greater than a predetermined minimum distance and/or for ensuring that the measured velocity does not exceed a predetermined maximum velocity.

4. An apparatus according to Claim 1, 2 or 3 wherein the collision protection apparatus further comprises:
- a rim which projects beyond at least one edge of the table, the rim being connected to the table by at least one damper for relative movement thereto.

5. An apparatus according to Claim 1, 2, 3 or 4 wherein the collision protection apparatus further comprises:
- a rim which projects beyond the edges of the table in a plane parallel to a direction of movement of the table;
- two dampers connecting a first side of the rim to a first side of the table;
- two connecting rods connecting a second side of the rim, adjacent to the first side, to the table, the connecting rods forming two opposite sides of a parallelogram in the plane parallel to the direction of movement.
wherein, in the event of collision on said first side of the rim, said connecting rods rotate relative to said table and rim and in the event of a collision on said second side, or a third side opposite said second side, said connecting rods deform.

6. An apparatus according to any one of Claims 1 to 4 wherein the collision protection apparatus further comprises:
- a rim which projects beyond the edges of the table in a plane parallel to a direction of movement of the table; and
- a respective first and second damper connecting each side of the rim to the table.

7. An apparatus according to Claim 6 wherein the respective first and second damper connects each corner of the rim to the table, and the respective first damper is connected between a first point on the rim and a second point on the table, and the respective second damper is connected between the first point on the rim and a third point on the table,
wherein the first, second and third points form a triangle in the plane horizontal to the direction of movement.

8. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
**characterized by**
- measuring the position and/or velocity of said moving part; and
- determining when a collision between a moving part of an apparatus and an obstacle is likely to occur.

9. A method according to Claim 8, wherein said step of measuring measures the position and velocity of said moving part and further comprising:
- comparing the measured position and velocity with known positions of obstacles and a known stopping distance of the moving part; and
- controlling the velocity of said moving part dependent upon the result of said comparison.

10. A method according to Claim 8, wherein said step of measuring measures the distance between said moving part and said obstacle and/or measures the velocity of said moving part towards said obstacle, and further comprising:
- controlling the velocity of the moving part to ensure that the measured distance is greater than a predetermined minimum distance and/or to ensure that the measured velocity does not exceed a predetermined maximum velocity.

11. An apparatus according to any one of Claims 1 to 7, wherein the support structure comprises a mask table for holding a mask and said collision protection apparatus is for protecting the mask table against damage from a collision.
